# EUROPEAN PATENT APPLICATION

(11) **EP 1 676 934 A1**
(43) Date of publication of application: **05.07.2006**
(21) Application number: 04107072.3
(22) Date of filing: 30.12.2004
(51) Int. Cl.: C23C 16/34, H01L 45/00

(54) **Chemical vapor deposition chamber for depositing titanium silicon nitride films for forming phase change memories**

(71) Applicant: STMicroelectronics S.r.l., 20041 Agrate Brianza (Milano) (IT)
(72) Inventor: LEE, Jong-Won, 94107, SAN FRANCISCO (US); HAMAMJY, Roger, 95130, SAN JOSE (US)
(74) Representative: Jorio, Paolo

(57) **Abstract**

Organometallic precursors may be utilized to form titanium silicon nitride films that act as heaters for phase change memories. By using a combination of TDMAT (tetrakis (dimethylamino) titanium) and TrDMASI (tris (dimethylamino) silane), for example in a metal organic chemical vapor deposition chamber (52), a relatively high percentage of silicon may be achieved in reasonable deposition times. Two separate bubblers (58a,58b) may be utilized to feed the two organometallic compounds in gaseous form to the deposition chamber (52) so that the relative proportions of the precursors can be readily controlled.

## Description

This invention relates generally to phase change memories.

Phase change memory devices use phase change materials, i.e., materials that may be electrically switched between a generally amorphous and a generally crystalline state, as an electronic memory. One type of memory element utilizes a phase change material that may be electrically switched between generally amorphous and generally crystalline local orders or between different detectable states of local order across the entire spectrum between completely amorphous and completely crystalline states.

Typical materials suitable for such an application include various chalcogenide elements. The state of the phase change materials is also non-volatile. When the memory is set in either a crystalline, semi-crystalline, amorphous, or semi-amorphous state representing a resistance value, that value is retained until reprogrammed, even if power is removed. This is because the programmed value represents a phase or physical state of the material (e.g., crystalline or amorphous).

In order to induce a phase change, a chalcogenide material may be subjected to heating by a heater. One desirable material for forming such heaters is titanium silicon nitride. Existing technology for forming titanium silicon nitride films generally involves first forming a thin titanium nitride film using tetrakis-dimethylamino titanium (TDMAT). Then, a silane treatment follows to add silicon to the titanium and nitride provided from the TDMAT. However, such techniques have generally provided relatively low amounts of silicon and relatively low electrical resistivity. Other techniques are also known, all of which have various problems.

Thus, there is a need for other ways of making heaters for phase change memories.

The object of the invention is thus to provide a method for manufacturing a titanium silicon nitride film overcoming the shortcomings of prior solutions.

According to the present invention, there are provided a method for forming a titanium silicon nitride film and a relative apparatus, as defined respectively in claims 1 and 11.

For the understanding of the present invention, a preferred embodiment is now described, purely as a non-limitative example, with reference to the enclosed drawings, wherein:
Figure 1 is a schematic diagram illustrating a memory in accordance with one embodiment of the present invention;
Figure 2 is a diagram illustrating a current-voltage characteristic of an access device;
Figures 3 and 4 are enlarged, cross-sectional views at subsequent stages of manufacture in accordance with one embodiment of the present invention;
Figure 5 is a schematic depiction of a chemical vapor deposition chamber in accordance with one embodiment of the present invention;
Figure 6 is a depiction of the chemical structure of TDMAT;
Figure 7 is a depiction of the chemical structure of TrDMASi;
Figures 8-12 are enlarged, cross-sectional views of the embodiment shown in Figure 4 at subsequent stages of manufacture in accordance with one embodiment of the present invention;
Figure 13 is an enlarged, cross-sectional view taken generally along the line 13-13 of Figure 14 of the embodiment shown in Figure 12 at a subsequent stage of manufacture in accordance with one embodiment of the present invention;
Figure 14 is an enlarged, top plan view reduced relative to Figure 13 in accordance with one embodiment of the present invention; and
Figure 15 is a schematic depiction of a system in accordance with one embodiment of the present invention.

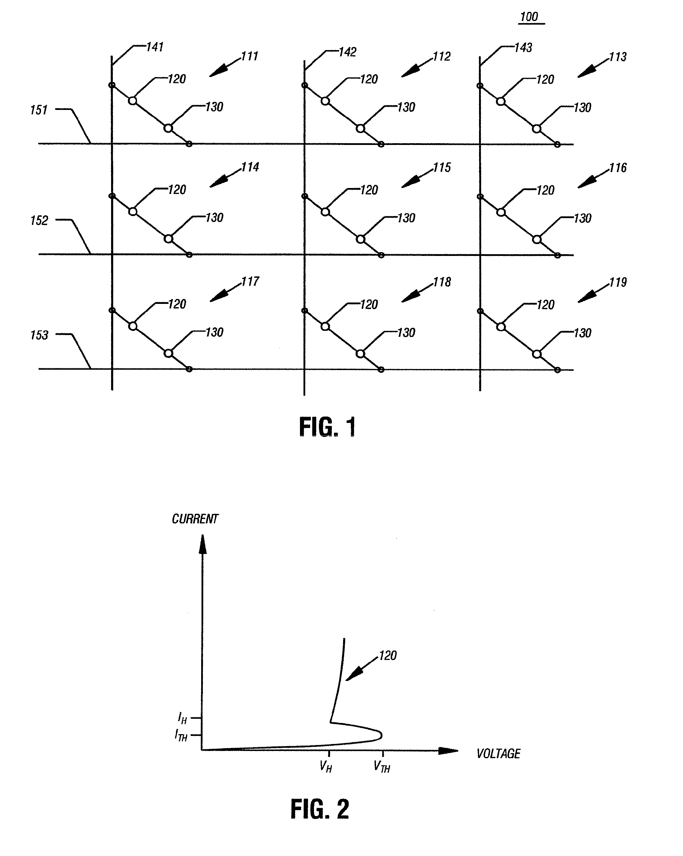

Turning to Figure 1, an embodiment of a memory 100 is illustrated. Memory 100 includes an nXn array of memory cells 111-119, wherein memory cells 111-119 each include a select device 120 and a memory element 130.

Memory elements 130 comprise a phase change material and memory 100 may be referred to as a phase change memory. A phase change material is a material having electrical properties (e.g. resistance, capacitance, etc.) that may be changed through the application of energy such as, for example, heat, light, voltage potential, or electrical current. Examples of a phase change material include a chalcogenide material.

A chalcogenide alloy is used in a memory element or in an electronic switch. A chalcogenide material is a material that includes at least one element from column VI of the periodic table or a material that includes one or more of the chalcogen elements, e.g., any of the elements of tellurium, sulfur, or selenium.

Memory 100 includes column lines 141-143 and row lines 151-153 to select a particular memory cell of the array during a write or read operation. Column lines 141-143 and row lines 151-153 may also be referred to as address lines since these lines may be used to address memory cells 111-119 during programming or reading. Column lines 141-143 may also be referred to as bit lines and row lines 151-153 may also be referred to as word lines.

Memory elements 130 are connected to row lines 151-153 and are coupled to column lines 141-143 via select device 120. While one select device 120 is depicted, more select devices may also be used. Therefore, when a particular memory cell (e.g., memory cell 115) is selected, voltage potentials are applied to the memory cell's associated column line (e.g., 142) and row line (e.g., 152) to apply a voltage potential across the memory cell.

Series connected select device 120 is used to access memory element 130 during programming or reading thereof. The select device 120 may be an ovonic threshold switch that is made of a chalcogenide alloy that does not exhibit an amorphous to crystalline phase change and which undergoes rapid, electric field initiated change in electrical conductivity that persists only so long as a holding voltage is present. Select device 120 operates as a switch that is either "off" or "on" depending on the amount of voltage potential applied across the memory cell, and more particularly whether the current through the select device exceeds its threshold current or voltage, which then triggers the device into the on state. The off state is a substantially electrically nonconductive state and the on state is a substantially conductive state, with less resistance than the off state. In the on state, the voltage across the select device is equal to its holding voltage VH plus IxRon, where Ron is the dynamic resistance from VH. For example, select device 120 has a threshold voltage and, if a voltage potential less than the threshold voltage of a select device 120 is applied across select device 120, then select device 120 remains "off" or in a relatively high resistive state so that little or no electrical current passes through the memory cell and most of the voltage drop from selected row to selected column is across the select device. Alternatively, if a voltage potential greater than the threshold voltage of select device 120 is applied across select device 120, then the select device 120 "turns on," i.e., operates in a relatively low resistive state so that electrical current passes through the memory cell. In other words, select device 120 is in a substantially electrically nonconductive state if less than a predetermined voltage potential, e.g., the threshold voltage, is applied across select device 120. Select device 120 is in a substantially conductive state if greater than the predetermined voltage potential is applied across select device 120. Select device 120 may also be referred to as an access device, an isolation device, or a switch.

In one embodiment, each select device 120 comprises a switching material such as, for example, a chalcogenide alloy, and may be referred to as an ovonic threshold switch, or simply an ovonic switch. The switching material of select device 120 is a material in a substantially amorphous state positioned between two electrodes that may be repeatedly and reversibly switched between a higher resistance "off" state (e.g., greater than about ten megaOhms) and a relatively lower resistance "on" state (e.g., about one thousand Ohms in series with VH) by application of a predetermined electrical current or voltage potential. In this embodiment, each select device 120 is a two terminal device that has a current-voltage (I-V) characteristic similar to a phase change memory element that is in the amorphous state. However, unlike a phase change memory element, the switching material of select device 120 may not change phase. That is, the switching material of select device 120 is not a programmable material, and, as a result, select device 120 may not be a memory device capable of storing information. For example, the switching material of select device 120 may remain permanently amorphous and the I-V characteristic may remain the same throughout the operating life. A representative example of I-V characteristics of select device 120 is shown in Figure 2.

Turning to Figure 2, in the low voltage or low electric field mode, i.e., where the voltage applied across select device 120 is less than a threshold voltage (labeled VTH), select device 120 is "off" or nonconducting, and exhibits a relatively high resistance, e.g., greater than about 10 megaOhms. Select device 120 remains in the off state until a sufficient voltage, e.g., VTH, is applied, or a sufficient current is applied, e.g., ITH, that switches select device 120 to a conductive, relatively low resistance on state. After a voltage potential greater than about VTH is applied across select device 120, the voltage potential across select device 120 drops ("snapbacks") to a holding voltage potential, labeled VH. Snapback refers to the voltage difference between VTH and VH of a select device.

In the on state, the voltage potential across select device 120 remains close to the holding voltage of VH as current passing through select device 120 is increased. Select device 120 remains on until the current through select device 120 drops below a holding current, labeled IH. Below this value, select device 120 turns off and returns to a relatively high resistance, nonconductive off state until the VTH and ITH are exceeded again.

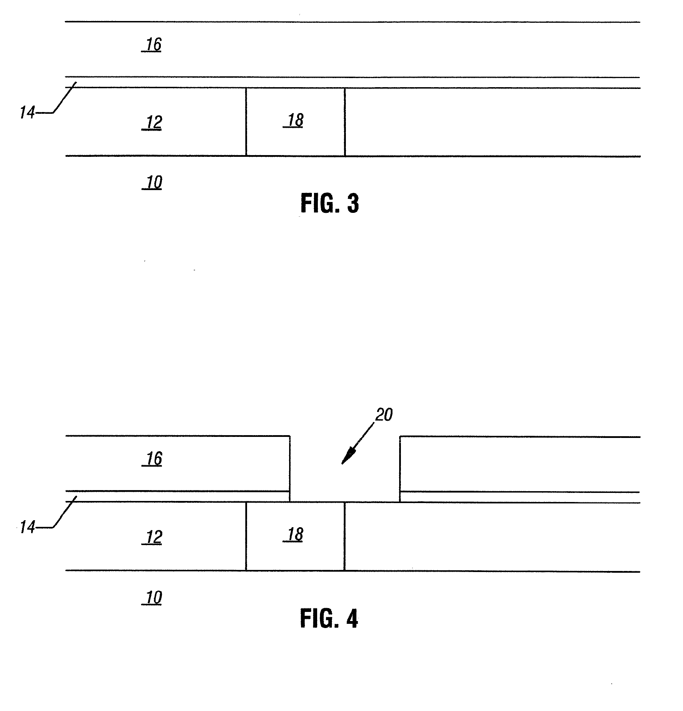

Referring to Figure 3, a substrate 10 includes a semiconductor substrate and one or more layers thereover. Over the substrate 10 is a silicon dioxide layer 12 having a conductor 18 formed therein in accordance with conventional damascene processing. In one embodiment, the conductor 18 is a row line 151-153 (Figure 1). The oxide layer 12 is covered by a nitride layer 14 and another oxide layer 16.

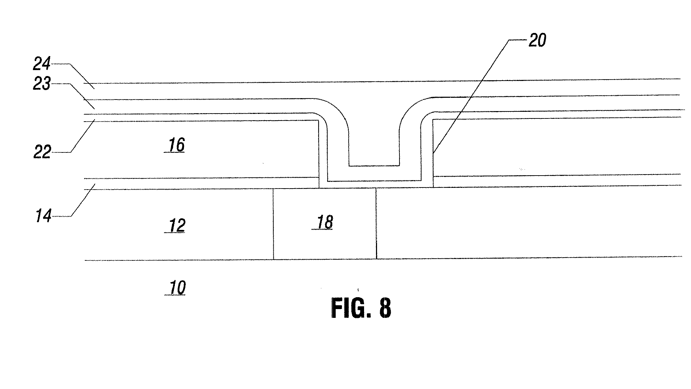

A wall trench 20 is formed through the layers 14 and 16 as shown in Figure 4. The trench 20 is first covered with a heater layer 22, for example of titanium silicon nitride, as shown in Figure 8.

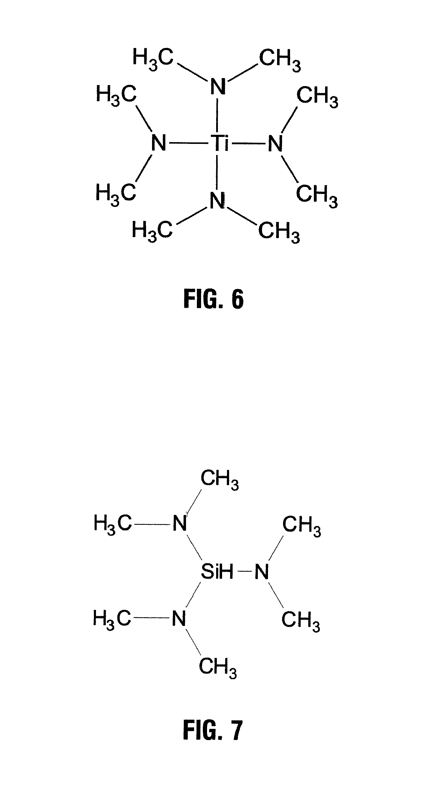

According to one embodiment of the present invention, tetrakis-(dimethylamino) titanium (TDMAT), whose chemical structure is shown in Figure 6, is utilized as a precursor to form the titanium silicon nitride film for phase change memory heater layer 22. A combination of TDMAT and tris-(dimethylamino) silane (TrDMASi) (whose chemical structure is shown in Figure 7) is utilized to form titanium silicon nitride films with relatively higher resistivity and relatively higher percentages of silicon. For example, titanium silicon nitride films with greater than 10 atomic percent silicon is formed. The higher the silicon content, the higher the resistivity of the film. The higher the film resistivity, the better it functions to heat a phase change material in response to current flow.

The two amine or organometallic precursors can be premixed or mixed in situ to form the titanium silicon nitride film, effectively, in a one-step process. In other words, a film of TDMAT need not be applied, followed by deposition of silane.

In particular, metal-organic chemical vapor deposition (MOCVD), plasma enhanced chemical vapor deposition (PECVD), laser assisted chemical vapor deposition, or atomic layer deposition (ALD) may be utilized. The ratio of those precursors can range from 5 to 95 atomic percent TDMAT and from 5 to 95 atomic percent TrDMASi. In one embodiment, the ratio of TDMAT to TrDMASi is about one to ten.

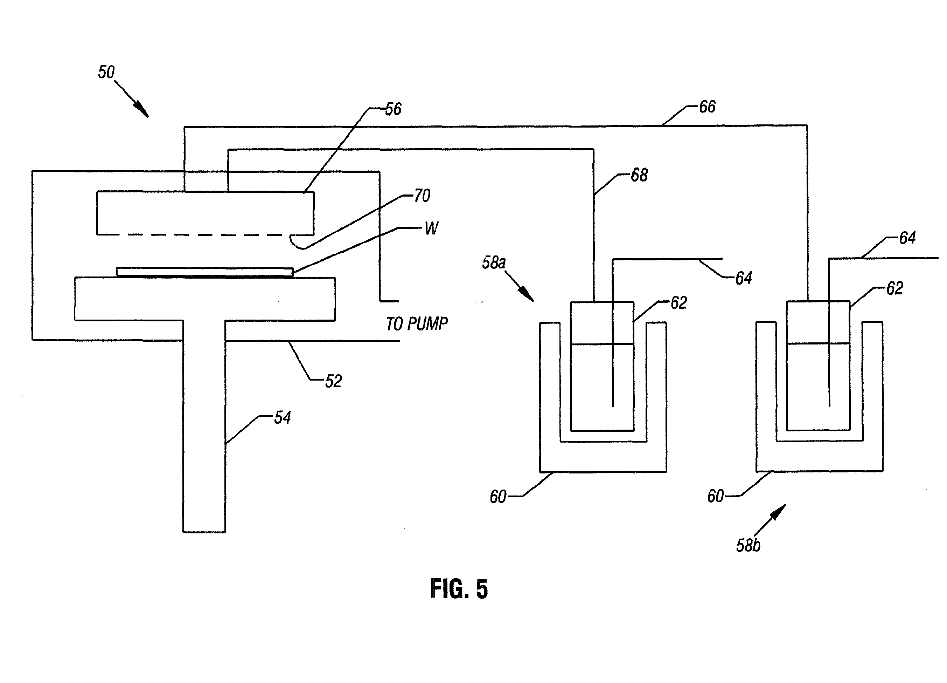

A variety of different deposition chamber configurations may be utilized. In Figure 5, a MOCVD apparatus 50 includes a chamber 52. A pedestal 54 supports the wafer W. A gas box 56 with a showerhead 70, having apertures therein, is provided within the chamber 52. The gas box 56 receives TrDMASi vapor from the bubbler 58b and TDMAT vapor from the bubbler 58a. Each bubbler chamber 62 is surrounded by a heater 60. A source of pressurized helium 64 acts as a diluent gas to the bubblers 58.

The amount of heat supplied by each heater 60 is controlled to control the proportion of liquid organometallic precursor which is converted to vapor and conveyed by a line 66 or 68 to the gas box 56. In other words, depending on the rate of vaporization, and the heat and pressure applied, one can control the amount of vapor from each bubbler 58. Thus, the operator can control the ratio of TDMAT to TrDMASi vapor that is supplied to form the titanium silicon nitride layer on the wafer W.

One reason for using two bubblers 58 is that it has been determined that the vaporization rates of the two organometallic precursors are different. Thus, if they were bubbled in one bubbler, the ratio of the precursors in the resulting titanium silicon nitride film would be fixed by their vaporization rates. Using separate bubblers 58 enables tailoring of the ratio of the precursors in the final film.

In one embodiment, the bubblers 58 are operated at around 50°C, while the chamber 52 is maintained between 300° and 500°C. Excess gas within the chamber 52 is withdrawn by a pump as indicated in Figure 5.

Generally, the more silicon in the titanium silicon nitride films, the higher resistivity of the resulting compound. In one advantageous embodiment, a ratio of TDMAT to TrDMASi of one to ten is utilized to achieve about 20 atomic percent silicon.

However, in other embodiments, a single bubbler may be utilized. In addition, direct liquid injection (DLI) may be utilized. In direct liquid injection, the deposition chamber is maintained at a temperature of from 300° to 500°C. In this case, a mixture of the two organometallic precursors, in liquid form, is directly injected into the chamber for in situ vaporization and deposition.

With reference to Figure 8, the heater layer 22 is preferably approximately 50 Angstroms thick. Over the heater layer 22 is a layer of nitride 23 of, e.g., about 200 Angstroms thickness. Finally, a layer of deposited oxide of e.g. about 900 Angstroms extends over the layer 23.

As shown in Figures 4 and 8, the trench 20 is situated with its center over the right edge of the conductor 18.

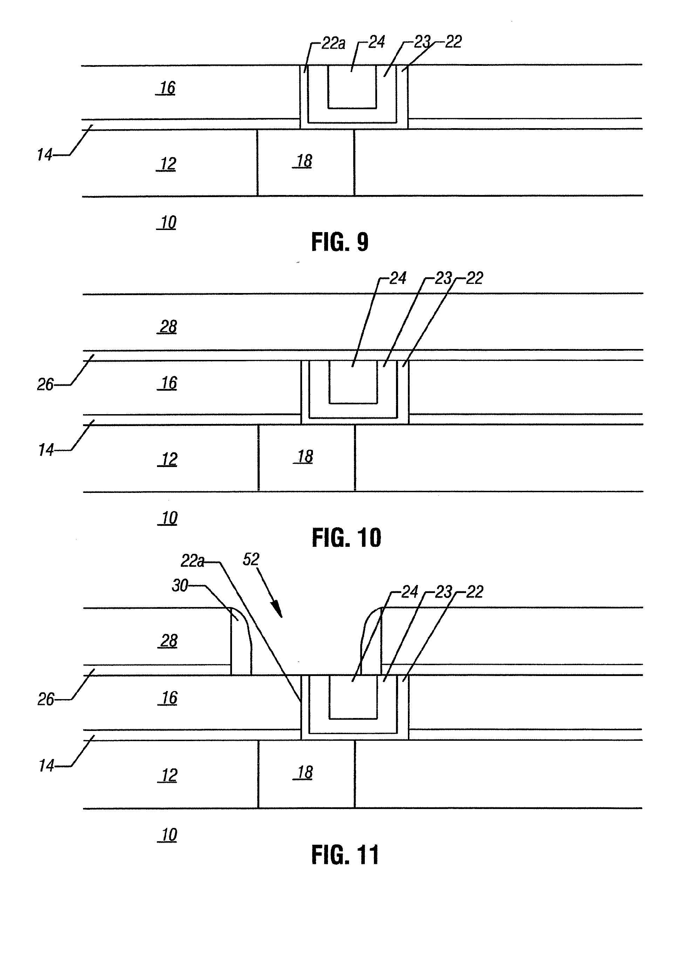

Referring to Figure 9, the structure shown in Figure 8 is planarized. As a result, the heater layer 22 that will act as a heater to change the phase of an overlying phase change material is U-shaped. Its offset positioning will enable the left upstanding arm of the heater layer 22 to act as a wall heater 22a, aligned under an overlying phase change material. The thickness of the wall heater 22a may be adjusted by adjusting the deposited thickness of the heater layer 22. Then, the wall heater 22a acts as a thin heating plate arranged on edge.

Then, another nitride layer 26 and oxide layer 28 are formed as indicated in Figure 10. Next, a trench 52 is formed through the layers 26 and 28 and sidewall spacers 30 are formed thereon. The sidewall spacers 30 are formed e.g. of nitride. In this embodiment, the trench 52, lined with the spacer 30, is aligned with the conductor 18, but because the trench 52 is wider than the conductor 18, the trench 52 extends laterally to either side of the conductor 18 as depicted in Figure 11.

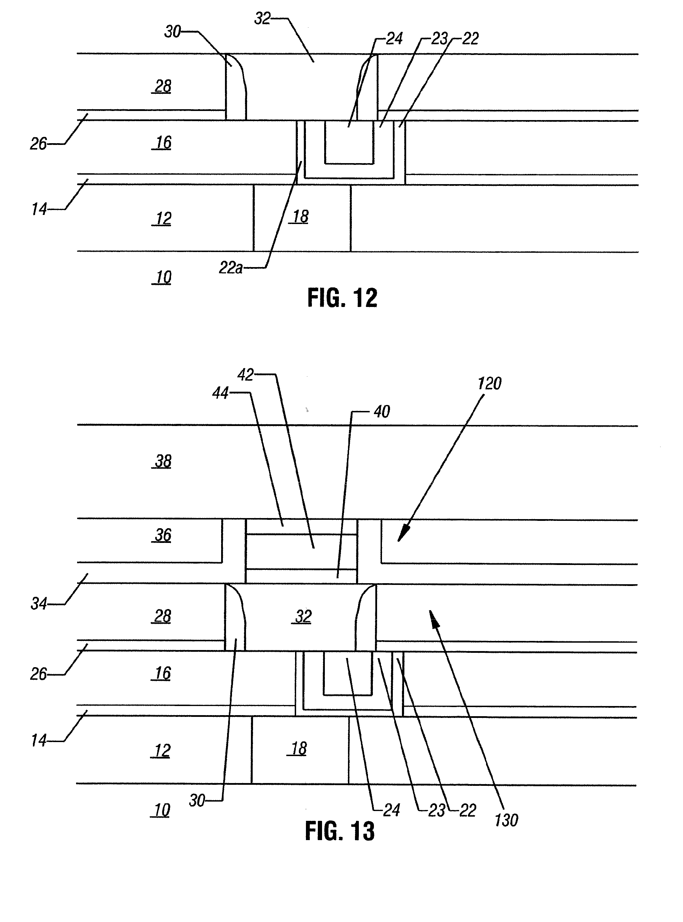

Then, as shown in Figure 12, the trench 52 is filled with a phase change memory material 32 that is subsequently planarized to achieved the structure shown in Figure 12. At this point the wall heater 22a is aligned centrally below the material 32. The material 32 forms a damascene memory element 130, defined within a trench in dielectric layers.

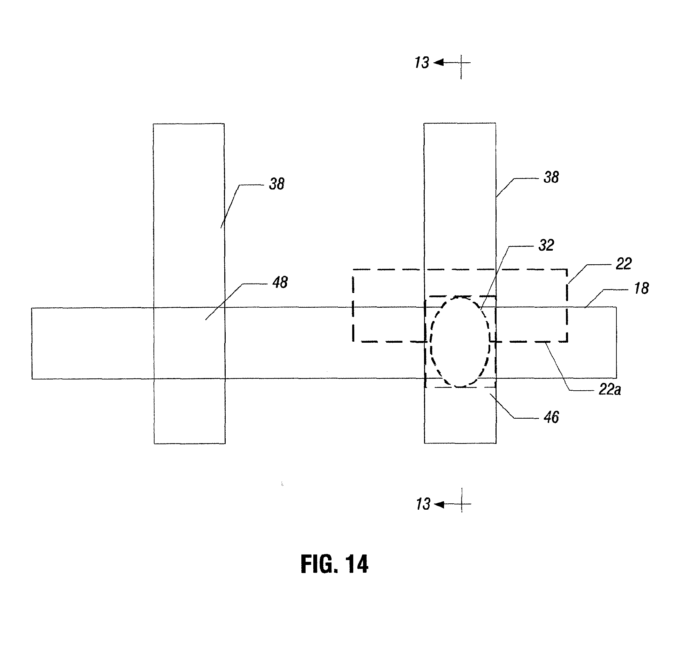

Thereafter, as shown in Figure 13, a select device or ovonic threshold device 120 (Figure 1) is formed over the memory material 32, that forms the memory element 130 (Figure 1). The select device 120 includes a switching material 42 formed between an upper electrode 44 and a lower electrode 40. The select device 120 is delimited by an L-shaped nitride layer 34, an oxide layer 36 and is overlaid by a conductor 38 that may be a column line 141-143 (Figure 1). The nitride layer 34 may be formed by depositing the layer 34 over the stack of the memory material 42 and electrodes 44 and 40; then the oxide layer 36 is deposed and the entire structure is planarized. This sequence is followed by the damascene formation of the upper conductor 38.

Thus, referring to Figure 14, the conductor 18 is transverse to two column conductors 38. On the right in Figure 14, the heater layer 22 is adjacent the memory material 32. The wall heater 22a is aligned centrally under the memory material 32 and centrally over the conductor 18. Current flow between conductors 18 and 38 results in electrical resistance heat developed by the wall heater 22a which heats the memory material 32.

The memory material 32 has an oval shape as a result of forming the trench 52 in an oval shape in Figure 11, also causing the spacer 30 to have a corresponding oval shape. Thus, the elongate shape of the phase change or memory material 32 in the column or upper electrode direction provides alignment tolerances between that memory material 32 and the overlying threshold device 120, as well as the underlying wall heater 22a. Other elongate shapes, including rectangles and ellipses, may also be used.

Because the wall heater 22a is U-shaped, its area may be reduced to a value below two-dimensional lithographic capabilities and the bulk of the heater layer 22 can be annealed or treated post-deposition.

Memory material 32 is a phase change, programmable material capable of being programmed into one of at least two memory states by applying a current to memory material 32 to alter the phase of memory material 32 between a substantially crystalline state and a substantially amorphous state, wherein a resistance of memory material 32 in the substantially amorphous state is greater than the resistance of memory material 32 in the substantially crystalline state.

Programming of memory material 32 to alter the state or phase of the memory material may be accomplished by applying voltage potentials to conductors 18 and 38, thereby generating a voltage potential across select device 120 and memory element 130. When the voltage potential is greater than the threshold voltage of select device 120 and memory element 130, then an electrical current flows through memory material 32 in response to the applied voltage potential, and may result in heating of memory material 32.

This heating alters the memory state or phase of memory material 32. Altering the phase or state of memory material 32 alters the electrical characteristic of memory material 32, e.g., the resistance of the material is altered by altering the phase of the memory material 32. Memory material 32 may also be referred to as a programmable resistive material.

In the "reset" state, memory material 32 is in an amorphous or semi-amorphous state and in the "set" state, memory material 32 is in an a crystalline or semi-crystalline state. The resistance of memory material 32 in the amorphous or semi-amorphous state is greater than the resistance of memory material 32 in the crystalline or semi-crystalline state. It is to be appreciated that the association of reset and set with amorphous and crystalline states, respectively, is a convention and that at least an opposite convention may be adopted.

Using electrical current, memory material 32 may be heated to a relatively higher temperature to amorphosize memory material 32 and "reset" memory material 32 (e.g., program memory material 32 to a logic "0" value). Heating the volume of memory material 32 to a relatively lower crystallization temperature may crystallize memory material 32 and "set" memory material 32 (e.g., program memory material 32 to a logic "1" value). Various resistances of memory material 32 may be achieved to store information by varying the amount of current flow and duration through the volume of memory material 32.

Although the scope of the present invention is not limited in this respect, the wall heater 22a may be titanium (Ti), titanium nitride (TiN), titanium tungsten (TiW), carbon (C), silicon carbide (SiC), titanium aluminum nitride (TiAIN), titanium silicon nitride (TiSiN), polycrystalline silicon, tantalum nitride (TaN), some combination of these films, or other suitable conductors or resistive conductors compatible with memory material 32.

Although the scope of the present invention is not limited in this respect, in one example, the composition of switching material 42 comprises a Si concentration of about 14%, a Te concentration of about 39%, an As concentration of about 37%, a Ge concentration of about 9%, and an In concentration of about 1%. In another example, the composition of switching material 42 comprises a Si concentration of about 14%, a Te concentration of about 39%, an As concentration of about 37%, a Ge concentration of about 9%, and a P concentration of about 1%. In these examples, the percentages are atomic percentages which total 100% of the atoms of the constituent elements.

In another embodiment, the composition for switching material 42 includes an alloy of arsenic (As), tellurium (Te), sulfur (S), germanium (Ge), selenium (Se), and antimony (Sb) with respective atomic percentages of 10%, 21%, 2%, 15%, 50%, and 2%.

Although the scope of the present invention is not limited in this respect, in other embodiments, switching material 42 includes Si, Te, As, Ge, sulfur (S), and selenium (Se). As an example, the composition of switching material 42 comprises a Si concentration of about 5%, a Te concentration of about 34%, an As concentration of about 28%, a Ge concentration of about 11%, a S concentration of about 21%, and a Se concentration of about 1%.

Electrodes 40, 44 are made of a conductive material, e.g. in the form of a thin film material having a thickness ranging from about 20 Å to about 2000 Å. In one embodiment, the thickness of the material 28 ranges from about 100 Å to about 1000 Å. In another embodiment, the thickness of the conductive material 40, 44 is about 300 Å. Suitable materials include titanium (Ti), titanium nitride (TiN), titanium tungsten (TiW), carbon (C), silicon carbide (SiC), titanium aluminum nitride (TiAlN), titanium silicon nitride (TiSiN), polycrystalline silicon, tantalum nitride (TaN), some combination of these films, or other suitable conductors or resistive conductors compatible with switching material 42.

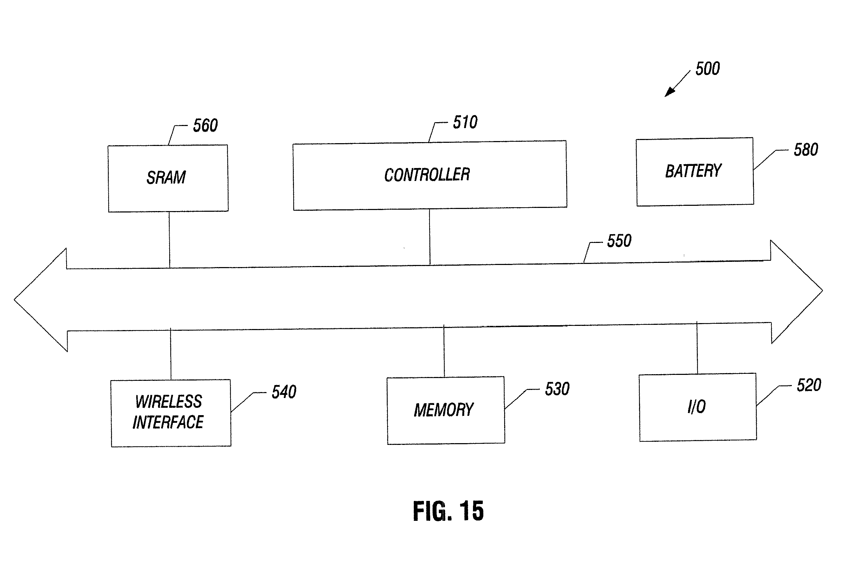

Turning to Figure 15, a portion of a system 500 in accordance with an embodiment of the present invention is described. System 500 may be used in wireless devices such as, for example, a personal digital assistant (PDA), a laptop or portable computer with wireless capability, a web tablet, a wireless telephone, a pager, an instant messaging device, a digital music player, a digital camera, or other devices that may be adapted to transmit and/or receive information wirelessly. System 500 may be used in any of the following systems: a wireless local area network (WLAN) system, a wireless personal area network (WPAN) system, a cellular network, although the scope of the present invention is not limited in this respect.

System 500 includes a controller 510, an input/output (I/O) device 520 (e.g. a keypad, display), a memory 530, a wireless interface 540 and a static random access memory (SRAM) 560, coupled to each other via a bus 550. It should be noted that the scope of the present invention is not limited to embodiments having any or all of these components.

Controller 510 comprises, for example, one or more microprocessors, digital signal processors, microcontrollers, or the like. Memory 530 may be used to store messages transmitted to or by system 500. Memory 500 may also optionally be used to store instructions that are executed by controller 510 during the operation of system 500, and may be used to store user data. Memory 530 may be provided by one or more different types of memory. For example, memory 530 may comprise any type of random access memory, a volatile memory, a non-volatile memory such as a flash memory and/or a memory such as memory 100 discussed herein.

I/O device 520 may be used by a user to generate a message. System 500 may use wireless interface 540 to transmit and receive messages to and from a wireless communication network with a radio frequency (RF) signal. Examples of wireless interface 540 may include an antenna or a wireless transceiver, although the scope of the present invention is not limited in this respect.

Finally, it is clear that numerous variations and modifications may be made to the method and apparatus described and illustrated herein, all falling within the scope of the invention as defined in the attached claims.

## Claims

1. A method of forming a titanium silicon nitride layer comprising:
independently generating vapors of tetrakis-(dimethylamino) titanium and tris-(dimethylamino) silane; and
combining said vapors in desired proportion to form a titanium silicon nitride layer (22).

2. The method of claim 1 including using at least 5 atomic percent tris-(dimethylamino) silane.

3. The method of claim 1 including forming a titanium silicon nitride layer having at least 10 atomic percent silicon.

4. The method of any of claims 1-3 including using metal-organic chemical vapor deposition to deposit said titanium silicon nitride layer (22).

5. The method of any of claims 1-4, including forming said vapors using separate bubblers (58a; 58b).

6. The method of claim 5 providing said vapors from said first and second bubblers (58a; 58b) to a deposition chamber (52).

7. The method of claim 6 including combining said vapors in a showerhead (70) in said deposition chamber (52).

8. The method of claim 1 including forming a titanium silicon nitride layer with at least 20 atomic percent silicon.

9. The method of any of the preceding claims, wherein said titanium silicon nitride layer (22) is heater for a phase change memory.

10. The method of any of claims 1-8 comprising forming a phase change memory device including:
forming a first conductor (18);
forming a heater (22) in contact with said first conductor;
forming a phase change memory region (32) in contact with said heater;
forming a select region (42) connected with said phase change memory region;
forming a second conductor (38) in contact with said select region, wherein forming a heater comprises forming said titanium silicon nitride layer (22).

11. An apparatus comprising:
a first bubbler (58a) to form a vapor of tetrakis-(dimethylamino) titanium;
a second bubbler (58b) to form a vapor of tris-(dimethylamino) silane; and
a deposition chamber (52) to deposit said vapors on a wafer to form a layer of titanium silicon nitride (22).

12. The apparatus of claim 11, wherein said bubblers (58a, 58b) include heaters (60).

13. The apparatus of claim 11 or 12, wherein said chamber 70 is a chemical vapor deposition chamber.

14. The apparatus of claim 13, wherein said vapors are applied to a wafer (W) through a showerhead (56).

15. The apparatus of any of claims 11-14, comprising means for adjusting the relative proportions of tetrakis-(dimethylamino) titanium and tris-(dimethylamino) silane and including means for controlling the rate of vaporization of said bubblers.
